# EUROPEAN PATENT SPECIFICATION

(11) **EP 3 274 155 B1**
(45) Date of publication and mention of the grant of the patent: **02.06.2021**
(21) Application number: 16714079.7
(22) Date of filing: 25.02.2016
(51) Int. Cl.: B29C 67/00, C08G 18/67, C08F 290/06, C08L 75/16

(54) **PHOTOCURABLE COMPOSITIONS FOR THREE-DIMENSIONAL PRINTING**
LICHTHÄRTBARE ZUSAMMENSETZUNGEN FÜR DREIDIMENSIONALES DRUCKEN
COMPOSITIONS PHOTODURCISSABLES POUR IMPRESSION TRIDIMENSIONNELLE

(30) Priority: 23.03.2015 US 201562136687 P
(43) Date of publication of application: 31.01.2018
(73) Proprietor: Dow Global Technologies LLC, Midland, MI 48674 (US)
(72) Inventor: LETKO, Christopher S., Freeport, TX 77541 (US); HEATH, William H., Freeport, TX 77541 (US); WILMOT, Nathan, Freeport, TX 77541 (US); CLAESSENS, Sven, 4530 AA Terneuzen (NL); HEANER, William L., Freeport, TX 77541 (US); COLSON, Adam C., Freeport, TX 77541 (US); KING, Stephen W., Freeport, TX 77541 (US); PENDERGAST, John G., Freeport, TX 77541 (US)
(74) Representative: Beck Greener LLP
(86) International application number: PCT/US2016/019499
(87) International publication number: WO 2016/153711

(56) References cited:
- WO-A2-2014/100238
- US-A1- 2002 008 333

## Description

### Field

Embodiments relate to a photocurable urethane acrylate/epoxy based composition for use in three-dimensional printing applications (also referred to as additive manufacturing), to three-dimensional printing applications that use the composition thereof, and three-dimensional printing processes that use the composition thereof.

### Introduction

Three-dimensional (3-D) printing allows for the production of objects directly from a computer aided design by using materials formulated for 3-D printing, which have been designed to generate objects that meet specific end-use requirements. For example, in instances where a flexible part is sought, materials that provide Shore A hardness, tensile strength, and percent elongation within specified ranges may be sought. As discussed in U.S. Patent No. 6,569,373, 3-D printing allows for the building of objects using two-dimensional layers. For example, one method known as stereolithography operates by first lowering a build platform into a vat of film forming material referred to as photoreactive resin. Then, a thin cross-section of a desired printed part is polymerized by tracing the shape's area with an actinic radiation source. Thereafter, subsequent cross-sectional layers are cured on top of previous layer(s) to obtain a 3-D printed object.
WO 2014/100238 A2 discloses elastomeric polymers produced from a composition comprising a polyene compound, an epoxy resin and optionally a radical initiator and a low molecular weight ene compound.

### Summary

Embodiments may be realized by providing a three-dimensional printing photocurable composition for a flexible material based object, in which the composition includes from 20 wt% to 70 wt% of an urethane acrylate component, from 20 wt% to 60 wt% of a multifunctional epoxide component, from 1 wt% to 15 wt% of a monomer component, and from 1 wt% to 8 wt% of a photoinitiator component, based on the total weight of the composition. The urethane acrylate component includes the capping reaction product of an acrylate and an isocyanate terminated prepolymer and the isocyanate-terminated prepolymer is the reaction product of a polyisocyanate and at least one polyol having a molecular weight of at least 3000 g/mol. The multifunctional epoxide component includes one or more multifunctional epoxides. The monomer component includes at least one of a multifunctional acrylate monomer and a multifunctional vinyl ether monomer The photoinitiator component includes one or more free radical photoinitiators and one or more cationic photoinitiators.

### Brief Description of the Drawings

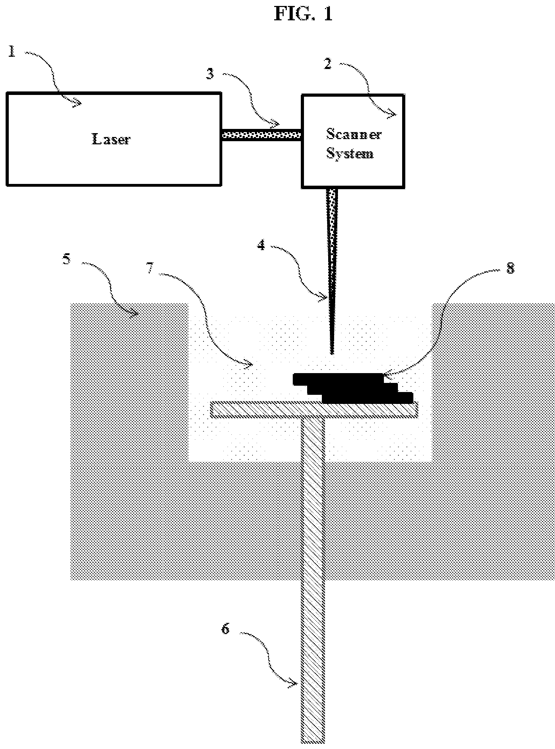

FIG. 1 illustrates an exemplary three-dimensional printing apparatus for use with the compositions according to embodiments. In particular, FIG. 1 illustrates an exemplary type of a stereolithography based three-dimensional printing apparatus.

### Detailed Description

Embodiments relate to photocurable compositions for use in printing three-dimensional flexible objects using three-dimensional printing apparatuses. By flexible objects it is meant an object having flexibility that is formed with a material having a measurable Shore A hardness of equal to or less than 95 and optionally equal to or greater than 40 (e.g., according to ASTM D2240). According to embodiments, the flexible material as a film has both a relatively high percent elongation at break (e.g., at least 50% and/or from 50% to 300%) and a relatively high tensile strength (e.g., at least 900 psi and/or from 900 psi to 3500 psi).

A variety of three-dimensional printing devices exist, which devices may differ by the method in which a feed material is processed to afford the final printed object. For example, the three-dimensional printing apparatus may utilize a stereolithography based printing process that includes building an object with a three-dimensional printable formulation and curing the object. Exemplary stereolithography based printing processes may utilize one of the following methods: (i) build objects by dispensing a resin formulation through an inkjet head and using an UV light source, (ii) build objects (e.g., upside down) in a bath and using a laser system, and (iii) build objects (e.g., in the opposite direction) using a bath and an UV light source. By way of example, one such stereolithography based printing device functions by curing successive layers of a photopolymer resin onto a substrate platform by tracing each cross-section with a laser. In another example, a photoactive resin may be processed using an inkjet head, where a cross-sectional pattern is deposited onto a surface and cured upon exposure to a UV lamp that follows the inkjet head.

Referring to FIG. 1, an exemplary stereolithography based three-dimensional printing apparatus, includes a laser 1 and a scanner system 2, for which the laser 1 provides a first laser beam 3 to the scanner system 2. The scanner system 2 provides a second laser beam 4 to a stereolithography vat 5. The stereolithography vat 5 includes a build platform 6 and a liquid photoreactive resin material 7 in which the build platform 6 is submerged. Using the second laser beam 4 and the liquid photoreactive resin material 7, film layers 8 (for forming a three-dimensional printed object) are formed on the build platform 6. The film layers 8 may be separately formed layers of solidified resin.

Photocurable compositions (e.g., three-dimensional printing photocurable compositions) for flexible material based objects, according to embodiments, include from 20 wt% to 70 wt% (e.g., from 25 wt% to 65 wt%, from 35 wt% to 60 wt%, from 35 wt% to 55 wt%, from 35 wt% to 50 wt%, from 45 wt% to 50 wt%, etc.) of an urethane acrylate component, based on the total weight of the photocurable composition. The urethane acrylate component includes the capping reaction product of an acrylate and an isocyanate terminated prepolymer, of which the isocyanate-terminated prepolymer is the reaction product of a polyisocyanate and at least a derived polyol having a molecular weight of at least 3000 g/mol (e.g., between 3000 g/mol and 12,000 g/mol, from 3500 g/mol to 10,000 g/mol, from 3800 g/mol to 8,200 g/mol, etc.). The urethane acrylate component may include one or more urethane acrylates that are the capping reaction product of an acrylate and an isocyanate terminated prepolymer, of which the isocyanate-terminated prepolymer being the reaction product of a polyisocyanate and at least a derived polyol having a molecular weight of at least 3000 g/mol.

The composition further includes from 20 wt% to 60 wt% (e.g., from 30 wt% to 60 wt%, from 30 wt% to 55 wt%, from 35 wt% to 50 wt%, from 35 wt% to 45 wt%, etc.) of a multifunctional epoxide component (multifunctional with respect to epoxide functionality), based on the total weight of the composition. The multifunctional epoxide component may include one or more multifunctional epoxides, e.g., one or more difunctional cycloaliphatic epoxides and/or one or more difunctional aromatic epoxides. For example, the multifunctional epoxide component may include one or more difunctional aromatic epoxides (such as a diepoxide that includes one aromatic group, e.g., divinylbenzene dioxide), in an amount from 5 wt% to 100 wt% (e.g., from 5 wt% to 60 wt%, 5 wt% to 40 wt%, from 5 wt% to 30 wt%, from 5 wt% to 20 wt%, from 5 wt% to 15 wt%, from 5 wt% to 10 wt%, etc.), based on the total weight of the multifunctional epoxide component.

A ratio of the urethane acrylate component to the multifunctional epoxide component may be from 0.5:1.5 to 1.5:0.5 and/or from 0.8:1.2 to 1:2.0.8. For example, when the amount of the urethane acrylate component is significantly higher (e.g., at least three times greater) than the amount of the multifunctional epoxide component, both sufficient percent elongation at break and sufficient tensile strength for forming a flexible object using three-dimensional printing may not be realized. When the amount of the multifunctional epoxide component is significantly higher (e.g., at least three times greater) than the amount of the urethane acrylate component, both sufficient percent elongation at break and sufficient tensile strength for forming a flexible object using three-dimensional printing may not be realized.

The composition also includes from 1 wt% to 15 wt% of a monomer component that includes at least one of a multifunctional acrylate monomer (having more than one acrylate functional group) and a multifunctional vinyl ether monomer (having more than one vinyl functional group), based on the total weight of the composition. Said in another way, the monomer component may include one or more multifunctional acrylate monomers and/or one or more multifunctional vinyl ether monomers. For example, the monomer component may include one or more diacrylate monomers and/or one or more divinyl ether monomers. The monomer component may act at least in part as a reactive diluent.

In addition, the composition includes from 1 wt% to 8 wt% of a photoinitiator component, based on the total weight of the composition. The photoinitiator component includes a free radical photoinitiator and a cationic photoinitiator. Both a free radical photoinitiator and a cationic photoinitiator are included.

### Urethane Acrylate Component

The urethane acrylate component includes at least one urethane acrylate derived from a polyol component that includes at least a polyol, e.g., that is synthesized using a double metal cyanide (DMC) catalyst or alkali metal hydroxide and/or alkali metal methoxide based catalyst. The urethane acrylate component includes the capping reaction product of an acrylate (one or more acrylates) and an isocyanate-terminated prepolymer component, whereas the isocyanate-terminated prepolymer component is the reaction product of a polyisocyanate (one or more polyisocyanate) and the polyol component that includes at least a polyol having a molecular weight of at least 3000 g/mol. The polyol may be a polyether polyol. For example, the polyol component may include any polyether polyols, and exclude other polyols such as polyester polyols.

For example, the urethane acrylate is the reaction product of a polyurethane based prepolymer, e.g., derived from a polyisocyanate and at least a polyol that is synthesized using only DMC based catalysts so as to form an isocyanate-terminated prepolymer, which has undergone acrylate capping. In addition to the DMC derived polyol, the reaction mixture for forming the polyurethane based prepolymer may include at least one other polyol (e.g., the DMC derived polyol may constitute a majority of greater than 75 wt% of the total amount of polyol(s) used with the optional remainder being another polyether polyol, polyester polyol, and/or a polyamine). The polyurethane based prepolymer is the reaction product of the polyol used to form the urethane acrylate and a polyisocyanate (such as diisocyanates that are known in the polyurethane art, which includes pure, polymeric, and modified forms of toluene diisocyanate -TDI and diphenylmethylene diisocyanate-MDI). According to an exemplary embodiment, the polyisocyanate is monomeric TDI or MDI (e.g., a blend of 2,2 and 2,6 isomers of TDI or 2,2 and 2,4 isomers of MDI) that has a nominal isocyanate functionality of at least 2.

The polyurethane based prepolymer may be formed in the presence of a catalyst, such as a tin-based catalyst and/or an amine-based catalyst that is known in the art. The polyurethane based prepolymer may be formed to have a free NCO (i.e., free isocyanate moiety) content of from 1 wt% to 7 wt% (e.g., 1 wt% to 5 wt%), based on the total weight of the resultant polyurethane based prepolymer.

The polyol component used to form the urethane acrylate (by way of forming the polyurethane based prepolymer) includes at least one polyol that has a high molecular weight of greater than 3000 g/mol (e.g., that is derived from a DMC catalyst). For example, the polyol component includes at least 75 wt% of polyol(s) having a molecular weight of greater than 3000 g/mol, based on the total weight of the polyol component. For example, the polyol(s) (as derived from a DMC catalyst or a non-DMC catalyst) may have a molecular weight greater than 3000 g/mol and less than 12000 g/mol.

The polyols(s), such as the at least one polyol that has a molecular weight of greater than 3000 grams/mol, may have a low level of unsaturation such that the polyol has a degree of unsaturation that is less than 0.100 meq/g polymer. The level of unsaturation for the polyol(s) may be less than 0.050 meq/g polymer, less than 0.020 meq/g polymer, and/or less than 0.015 meq/g polymer. The polyol(s) may have a low monol content, e.g., less than 3.0 wt% to an unmeasurably low amount, based on the total weight of the polyol component used to form the urethane acrylate. Further, the polyol(s) may have both a high molecular weight and a low polydispersity (Mw/Mn). For example, the polydispersity may be from 1.0 to 1.2.

In exemplary embodiments, at least one polyol used to form the urethane acrylate is not derived from an alkali metal hydroxide and/or alkali metal methoxide based catalyst. In particular, at least one polyol may be derived only from a DMC based catalyst (and may not be derived from a KOH based catalyst or other alkali metal hydroxides and/or alkali metal methoxide based catalysts). Polyoxypropylene including polyols produced with a KOH based catalyst, may lead to conversion of hydroxyl end-groups to vinyl groups that are unreactive to conventional coupling reactions. For example, during conventional base catalyzed oxypropylation, a competing rearrangement of propylene oxide into allyl alcohol continually generates an oxyalkylatable unsaturated monol during the course of the reaction. The polyoxyalkylation of this monomeric species may produce monols of broad molecular weight range, which increase polydispersity and decrease the overall functionality of the resultant product. Further, high molecular weight polyols produced with a KOH based catalyst may have a high level of unsaturation, e.g., of greater than 0.15 meq/g polymer. In contrast, high molecular weight polyols produced with a DMC based catalyst may have a lower level of unsaturation, e.g., of less than 0.01 meq/g polymer. This could equate to 28% versus 2% of unreactive end-groups on KOH based catalyst vs. DMC based catalyst derived polyols respectively.

The polyurethane based prepolymer is capped with acrylate(s) to form the urethane acrylate, according to embodiments. The acrylate capping reaction may be performed in the presence of a catalyst, such as a tin-based catalyst and/or an amine-based catalyst that is known in the art. The acrylate capping may be performed with a monoacrylate. For example, the acrylate capping may be performed using acrylate(s) that is different from any of the multifunctional acrylates included in the monomer component. The urethane acrylate may contain urethane groups (and optionally urea groups in which the inclusion of such groups is known in the art) derived from the polyurethane based prepolymer (that is has isocyanate terminated groups), at least 90% of which are capped with an acrylate compound. Acrylate compounds may be understood as including an acrylate ion that has the following molecular formula:

CH₂=CHCOO⁻ Formula 1

The acrylate capping of the polyurethane based prepolymer may be performed after the polyurethane based prepolymer is formed. Exemplary acrylates include hydroxyethyl acrylate, hydroxyethyl methacrylate, hydroxypropyl acrylate, and hydroxypropyl methacrylate.

For example, the polyurethane based prepolymer is the reaction product of a polyisocyanate and the polyol derived from a DMC based catalyst. The urethane acrylate may be the reaction product of the polyurethane based prepolymer and at least one acrylate. For example, the urethane acrylate may be prepared as the reaction product of a terminally unsaturated isocyanate containing polyurethane oligomer and an alkoxylated polyhydric alcohol, e.g., as discussed in U.S. Patent No. 5,578,693. The terminally unsaturated isocyanate containing polyurethane oligomer may be prepared by reacting at least one polyisocyanate with at least one polyol to form an isocyanate terminated prepolymer, reacting a portion of the unreacted terminal isocyanate groups with at least one hydroxyl-functional acrylate or hydroxyl-functional vinyl ether to form a terminally unsaturated isocyanate-containing urethane oligomer, and reacting the remaining terminal isocyanate groups with at least one alkoxylated polyhydric alcohol, as discussed in U.S. Patent No. 5,578,693.

The three-dimensional printing composition may exclude other urethane acrylates, and include only urethane acrylates that are a capping reaction product of an acrylate and an isocyanate-terminated prepolymer, the isocyanate-terminated prepolymer being the reaction product of a polyisocyanate and at least a derived polyol having a molecular weight of at least 3000 g/mol. For example, the composition may exclude directly functionalized (meth)acrylated urethane oligomer derivatives of polyethylene glycol and a (meth)acrylated polyol oligomer.

The urethane acrylate component may be a pre-formed component that is formed prior to forming the composition (e.g., prior to mixing) with the multifunctional epoxide component, the monomer component, and photoinitiator component. Said in another way, the urethane acrylate component may be formed prior to forming the photocurable composition.

### Multifunctional Epoxide Component

Embodiments include a multifunctional epoxide component, e.g., that includes one or more difunctional (i.e., includes two epoxy functional groups) cycloaliphatic epoxides and/or one or more difunctional aromatic epoxides. Cycloaliphatic epoxides include one or more cycloaliphatic rings in the molecule to which an epoxy functional group (e.g., C₂H₂O) is fused to the cycloaliphatic ring. In exemplary embodiments, the difunctional cycloaliphatic epoxides may include two cycloaliphatic rings that each have one epoxy functional group attached thereon, so as the epoxy functional groups are only attached to cycloaliphatic rings. The two different cycloaliphatic rings may be connected by a carboxylate group. The two cycloaliphatic rings may each include 5 to 6 carbon atoms. An exemplary, difunctional cycloaliphatic epoxide is 3,4-epoxycyclohexylmethyl-3,4-epoxycyclohexane carboxylate.

In exemplary embodiments, the photocurable composition may exclude other epoxies, except difunctional cycloaliphatic epoxides and/or difunctional aromatic epoxides. For example, the composition may exclude any glycidyl type aliphatic epoxy resins, Bisphenol A based epoxy resins, Bisphenol F based based epoxy resins, Novolac epoxy resins, and glycidylamine epoxy resins that are not difunctional cycloaliphatic epoxides and/or difunctional aromatic epoxides.

### Monomer Component

The monomer component that includes at least one of a multifunctional acrylate monomer (i.e., a monomer that includes two or more acrylate functional groups) and a multifunctional vinyl ether monomer (i.e., a monomer that includes two or more vinyl groups). For example, the monomer component may include a diacrylate monomer and/or a divinyl ether monomer. The monomer component may act at least in part as a reactive diluent.

The monomer component may include from 90 wt% to 100 wt% of one or more diacrylate monomers, based on the total weight of the monomer component, from 90 wt% to 100 wt% of one or more divinyl ether monomers, based on the total weight of the monomer component, or from 90 wt% to 100 wt% of one or more diacrylate monomers and one or more divinyl ether monomers, based on the total weight of the monomer component.

Exemplary multifunctional acrylates monomers include urethane dimethacrylate, 1,3-glycerol dimethacrylate, 1,6-hexanediol diacrylate, 1,6-hexanediol dimethacrylate, 1,4-butanediol diacrylate, 1,4-butanediol dimethacrylate, and triethylene glycol dimethacrylate. Exemplary multifunctional vinyl ether monomers include diethylene glycol divinyl ether, triethylene glycol divinyl ether, 1,4-cylcohexane dimethylol divinyl ether, dipropylene glycol divinyl ether, tripropylene glycol divinyl ether, 1,6-hexanediol divinyl ether, and 1,4-butanediol divinyl ether.

### Photoinitiator Component

The photoinitiator component includes one or more free radical photoinitiators and one or more cationic photoinitiators. For example, photoinitiators known in the art for use in compositions for three-dimensional printing may be used, e.g., photoinitiators that are known in the art use with stereolithography based processes may be used.

Exemplary free radical photoinitiators include a compound that produces a free radical on exposure to radiation such as ultraviolet and/or visible radiation, in an amount sufficient to initiate a polymerization reaction. The free-radical photoinitiator may be a single compound, a mixture of two or more active compounds, or a combination of two or more different compounds (such as co-initiators). Exemplary cationic photoinitiators include compounds that form aprotic acids or Bronsted acids upon exposure to radiation such as ultraviolet and/or visible radiation, in an amount sufficient to initiate polymerization. The cationic photoinitiator used may be a single compound, a mixture of two or more active compounds, or a combination of two or more different compounds (such as co-initiators). The cationic photoinitiator may be used in conjuction with a photosensitizer, e.g. 9,10-diethoxyanthracene, to enable the cationic photoinitiator to be activated over a broader range of wavelengths.

### Photocurable Composition

The composition may be used to prepare materials for use with three-dimensional printing technology, e.g., with stereolithography based three-dimensional printing processes, that have a desired Shore A hardness (e.g., from 40 to 95), good percent elongation values (e.g., at least 50%), and a good tensile strength (e.g., at least 900 psi). The combination of good percent elongation and good tensile strength is highly desired in flexible objects formed using three-dimensional printing processes. For example, since tensile strength and percent elongation are typically regarded as inversely proportional, the raising of one of the properties usually results in a decrease of the other property. Therefore, materials that provide a good balance of percent elongation and tensile strength, at the desired Shore A hardness, are sought.

In exemplary embodiments, the composition may combine an urethane acrylate, a difunctional epoxide such as 3,4-epoxycyclohexylmethyl 3,4-epoxycyclohexane carboxylate, and a monomer/diluent such as a diacrylate or divinyl ether in the presence of photoinitiators and actinic radiation in order to prepare a material for forming a flexible three-dimensional printed object, as shown below in Schematic 1. For example, the process in Schematic 1, may utilize a stereolithography based three-dimensional printing process.

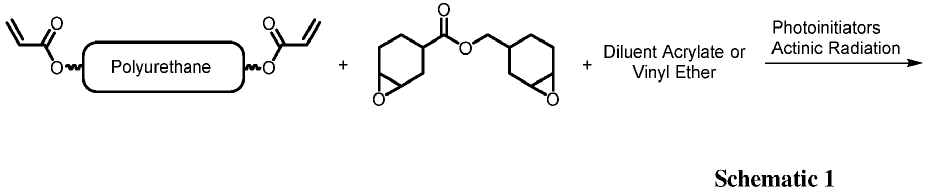

In exemplary embodiments, the composition may combine the urethane acrylate, the difunctional epoxides 3,4-epoxycyclohexylmethyl 3,4-epoxycyclohexane carboxylate and divinylbenzene dioxide, and monomers of diacrylate or divinyl ether in the presence of photoinitiators and actinic radiation in order to prepare a material for forming a flexible three-dimensional printed object, as shown below in Schematic 2. For example, the process in Schematic 2, may utilize a stereolithography based three-dimensional printing process.

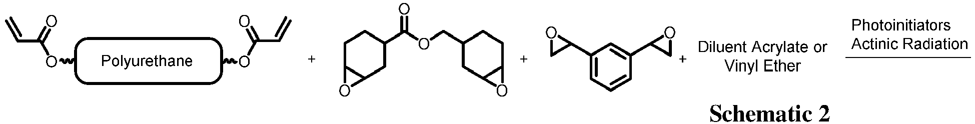

The resultant reaction product of the composition may include at least two different phases: (1) a relatively soft polyol phase, and (2) a relatively harder epoxy/acrylate/urethane phase. Such materials may exhibit at least two different glass transition temperature peaks when referring to the DMA (dynamic mechanical analysis) data, e.g., may exhibit a phase-separated morphology in which a combined glass-rubber state is realized over a range of temperatures. With the presence of distinct glass transition temperatures, at any temperature between the two glass transition temperature peaks, a rubbery phase that has already transitioned from a brittle glassy phase into a rubber state and a brittle glassy phase that is yet to transition into a rubbery state co-exist. This may allow for a more uniform mechanical behavior between the two glass transition temperatures of the respective phases, and may provide for enhanced properties when used as photocurable compositions for three-dimensional printing of flexible objects. For example, the presence of a rubbery phase allows for a material that is deformable and the presence of a rigid glassy phase provides a reinforcing mechanism that provides for sufficient Shore A hardness, increases tensile strength, and/or increases mechanical integrity (such as storage modulus) of the material. In contrast, materials that exhibit only one glass transition temperature are completely a glass below the glass transition temperature and hence brittle and may be unable to provide sufficient percent elongation at break and tensile strength for photocurable compositions for three-dimensional printing of flexible objects. Such a single glass transition material may be completely a rubber above the glass transition temperature, where the material may not have sufficient mechanical strength for three-dimensional printed flexible objects.

All parts and percentages are by weight unless otherwise indicated. All molecular weight values are based on number average molecular weight, unless indicated otherwise. All references to functionality are based on nominal functionality (as would be understood by a person of ordinary skill in the art), unless indicated otherwise.

### Examples

The Examples are prepared as discussed below. In particular, first the urethane acrylate is synthesized. Then, exemplary and comparative compositions are prepared and analyzed. The following description is approximate, e.g., with respect to material properties and process specifications.

### Urethane Acrylate Synthesis

Urethane acrylates are prepared with polyols via the process described below, in which firstly a prepolymer is synthesized and secondly an acrylate capping procedure is performed on the resultant prepolymer.

In the urethane acrylate synthesis, the materials principally used are the following:

| | |
|---|---|
| Isocyanate | A monomeric toluene diisocyanate, i.e., TDI, blend, having approximately 80 wt% of the 2,4 isomer of TDI and approximately 20 wt% of the 2,6 isomer of TDI (available from The Dow Chemical Company as VORANATE™ T-80). |
| Polyol 1 | A DMC catalyzed polypropylene based diol (i.e., nominal hydroxyl functionality of 2), having a molecular weight of approximately 4000 g/mol and a degree of unsaturation of approximately 0.007 milliequivalence/gram (available from The Dow Chemical Company as VORANOL™ LM 4000). |
| Polyol 2 | A DMC catalyzed polypropylene based diol, having a molecular weight of approximately 8000 g/mol (available from The Dow Chemical Company as VORANOL™ LM 8000). |
| Acrylate | A hydroxyethyl acrylate (HEA) hydroxyalkyl ester monomer based solution including at least about 95 wt% of HEA (available from The Dow Chemical Company as ROCRYL™ 420). |

Step 1 includes prepolymer synthesis using the polyol. In particular, in Step 1, Isocyanate (approximately 75 grams) and Polyol 1 (approximately 827 grams) are charged to a dry 2-liter 4-neck round bottom flask equipped with overhead stirring, temperature control probe, addition funnel, and nitrogen inlet. The reactor is heated to 80 °C and a drop of dibutyltin dilaurate is added. The reaction is stirred for approximately 2 hours. The final NCO content of the Prepolymer (i.e., isocyanate moiety content) is approximately 2% as determined by titration.

Step 2 includes acrylate capping of the resultant Prepolymer from Step 1. In particular, in Step 2, the acrylate (approximately 54.3 grams) is added to the resultant Prepolymer (approximately 881 grams) from above, and the reaction is stirred at 45 °C for 2 hours. Residual isocyanate is observed by FT-IR (-2250 cm⁻¹). An additional drop of dibutyltin dilaurate is added and stirring is continued for an additional 2 hours, after which time there was no NCO stretch as observed by FT-IR analysis (i.e., there is no observable excitation mode for that isocyanate functional group in the FT-IR analysis such that the NCO stretch is equal to absorbance when using FT-IR analysis). The resultant material is referenced as Urethane Acrylate 1, which is used in the 3D Printing Formulation, and is discussed below.

An exemplary schematic of the Urethane Acrylate synthesis is illustrated as the following:

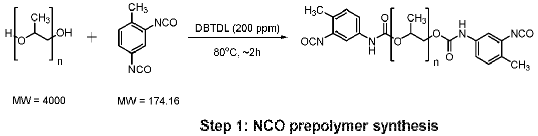

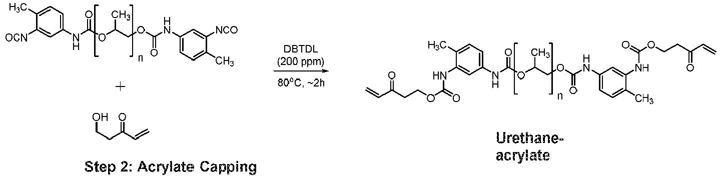

Based on the above, it is shown that the Urethane Acrylate 1 includes an isocyanate-terminated prepolymer derived acrylate capped aromatic urethanes.

Urethane Acrylate 2 is prepared using the same method as described above with respect to Urethane Acrylate 1, except a higher molecular weight polyol is used (i.e., Polyol 2 having a molecular weight of 8000 g/mol).

### Three Dimensional Printable Formulation

In the preparation of the 3D Printing Composition, the materials principally used are the following:

| | |
|---|---|
| Urethane Acrylate 1 | A di-acrylate functional urethane-acrylate prepolymer, synthesized as discussed above. |
| Urethane Acrylate 2 | A di-acrylate functional urethane-acrylate prepolymer, synthesized as discussed above. |
| Epoxide 1 | 3,4-Epoxycyclohexylmethyl-3,4-epoxycyclohexane carboxylate, i.e., a cycloaliphatic diepoxide monomer, having a molecular weight of 252 g/mol (available from Sigma-Aldrich® or Synasia). |
| Epoxide 2 | Divinylbenzene Dioxide, a difunctional epoxide, which may be prepared by reacting a divinylbenzene and hydrogen peroxide. |
| Acrylate | 1,6-hexanediol diacrylate, i.e., a diacrylate monomer, (available as SR238 from ARKEMA). |
| Vinyl Ether | Triethyleneglycol Divinyl Ether, i.e., a divinyl ether monomer, that is also known as 3,6,9,12-Tetraoxatetradeca-1,13-diene, having a molecular weight of 202 g/mol (available from BASF). |
| Photoinitiator 1 | 1-Hydroxy-cyclohexyl-phenyl-ketone, which is a free radical initiator having a molecular weight of 204 g/mol (available as IRGACURE® 184 from Ciba®), as a 50 wt% solution in propylene carbonate. |
| Photoinitiator 2 | Triarylsulfonium hexafluorophosphate salts, mixed in 50 wt% of propylene carbonate, which is a cationic photoinitiator (available from Sigma-Aldrich®). |

Working Examples 1 to 7 are prepared according to the approximate formulations shown in Table 1, below.

**Table 1**

| | **Example 1** | **Example 2** | **Example 3** | **Example 4** | **Example 5** | **Example 6** | **Example 7** |
|---|---|---|---|---|---|---|---|
| **Three-Dimensional Printable Formulation** | | | | | | | |
| Urethane Acrylate 1 (wt%) | 47.6 | 47.6 | 47.6 | 47.6 | 47.6 | 45.3 | -- |
| Urethane Acrylate 2 (wt%) | -- | -- | -- | -- | -- | -- | 47.6 |
| Epoxide 1 (wt%) | 42.8 | 35.7 | 42.8 | 36.2 | 33.3 | 29.5 | 33.3 |
| Epoxide 2 (wt%) | -- | -- | -- | -- | 9.5 | 9.2 | 9.5 |
| Acrylate (wt%) | 4.8 | 11.9 | -- | 5.7 | 4.8 | 11.3 | 4.8 |
| Vinyl Ether (wt%) | -- | -- | 4.8 | 5.7 | -- | -- | -- |
| Photoinitiator 1 (wt%) | 1.9 | 1.9 | 1.9 | 1.9 | 1.9 | 1.9 | 1.9 |
| Photoinitiator 2 (wt%) | 2.8 | 2.8 | 2.8 | 2.8 | 2.8 | 2.8 | 2.8 |

| **Three-Dimensional Printable Film Properties** | | | | | | | |
|---|---|---|---|---|---|---|---|
| % Elongation at Break | 179 | 95 | 219 | 176 | 69 | 52 | 67 |
| Tensile Strength (psi) | 1622 | 1443 | 1211 | 969 | 2515 | 2482 | 2279 |
| Shore A Hardness | 70 | 80 | 60 | 60 | 80 | 80 | 90 |
| Storage Modulus @ 50 °C (MPa) | 17.0 | 12.9 | 13.0 | 5.2 | 149 | 273 | 117 |

% Elongation at break and Tensile strength are calculated according to ASTM D1708. Shore A Hardness is measured according to a modified version of ASTM D2240, using folded film samples. Storage Modulus at 50 °C is extracted from dynamic mechanical analysis (DMA) data. DMA sample bars of the dimension 47.5 mm x 7 mm were cut from films using a die press and were subsequently analyzed using a TA Instruments Ares II Rheometer in torsion mode. The linear viscoelastic response (4% strain with auto strain adjustment) was measured in oscillatory mode (1 Hz) with a 3 °C/min temperature ramp from -90 °C to 200 °C.

Comparative Examples A to D are prepared according to the approximate formulations shown in Table 2, below. Comparative Examples A and B, which do not contain an epoxide component. Comparative Example C includes more than 70 wt% of the Urethane Acrylate 1, based on the total weight of the Three-Dimensional Printable Formulation. Comparative Example D includes more than 60 wt% of the Epoxide 1.

**Table 2**

| | **Example A** | **Example B** | **Example C** | **Example D** |
|---|---|---|---|---|
| **Three-Dimensional Printable Formulation** | | | | |
| Urethane Acrylate 1 (wt%) | 85.7 | 93.0 | 71.4 | 19.0 |
| Epoxide 1 (wt%) | -- | -- | 19.0 | 71.4 |
| Acrylate (wt%) | 12.3 | 5.0 | 4.8 | 4.8 |
| Vinyl 1 (wt%) | -- | -- | -- | -- |
| Vinyl 2 (wt%) | -- | -- | -- | -- |
| Photoinitiator 1 (wt%) | 2.0 | 2.0 | 1.9 | 1.9 |
| Photoinitiator 2 (wt%) | | | 2.8 | 2.8 |

| **Three-Dimensional Printable Film Properties** | | | | |
|---|---|---|---|---|
| % Elongation at Break | 86 | 70 | 116 | 14 |
| Tensile Strength (psi) | 606 | 252 | 410 | 5156 |

| | | | | |
|---|---|---|---|---|
| N/A = not available | | | | |

Referring to Comparative Examples A to D, it is seen that the combination of both a relatively high % elongation at break and a tensile strength is not realized.

In addition, properties of commercial materials were acquired from technical data sheets available online from Stratasys® and 3D® Systems. With respect to the Table 3, below, such commercial materials exhibit low % elongation at break or low tensile strength. In contrast, reference to Table 1, above, the Working Examples 1-7 exhibit the combination of both a relatively high % elongation at break and a relatively high tensile strength.

**Table 3**

| | **Example E** | **Example F** | **Example G** | **Example H** | **Example I** |
|---|---|---|---|---|---|
| % Elongation at Break | 170-220 (ASTM D-412) | 45-55 (ASTM D-412) | 45-55 (ASTM D-412) | 16 (ASTM D-638) | 151 (ASTM D-638) |
| Tensile Strength (psi) | 115-220 (ASTM D-412) | 115-350 (ASTM D-412) | 435-725 (ASTM D-412) | 5511 (ASTM D-638) | 335 (ASTM D-638) |
| Shore A Hardness | 26-28 (ASTM D-2240) | 60-62 (ASTM D-2240) | 73-77 (ASTM D-2240) | -- | 55-80 (ASTM D-2240) |
| Shore D Hardness | -- | -- | -- | 80 | -- |

Example E is TangoBlackPlus FLX980 (available from Stratasys®), which is an acrylic based formulation for three dimensional printing. Example F is TangoBlack FLX973 (available from Stratasys®), which is an acrylic based formulation for three dimensional printing. Example G is TangoGray FLX950 (available from Stratasys®), which is an acrylic based formulation for three dimensional printing. Example H is Visijet® SL Flex (available from 3D® Systems), which is an epoxy resin based three dimensional printing material. Example I is DuraForm® Flex w/Flexseal (available from 3D® Systems), which is a thermoplastic elastomeric material for use in selective laser sintering (SLS), which is different from a stereolithography based process (SLA). As is shown, with respect to Working Examples 1 to 7, the composition according to embodiments provides for good elongation and break, good tensile strength, and good Shore A hardness.

## Claims

1. A three-dimensional printing photocurable composition for a flexible material based object, the composition comprising:
from 20 wt% to 70 wt% of an urethane acrylate component, based on the total weight of the composition, the urethane acrylate component including the capping reaction product of an acrylate and an isocyanate-terminated prepolymer, the isocyanate-terminated prepolymer being the reaction product of a polyisocyanate and at least one polyol having a molecular weight of at least 3000 g/mol;
from 20 wt% to 60 wt% of a multifunctional epoxide component that includes one or more multifunctional epoxides, based on the total weight of the composition;
from 1 wt% to 15 wt% of a monomer component that includes at least one of a multifunctional acrylate monomer and a multifunctional vinyl ether monomer, based on the total weight of the composition; and
from 1 wt% to 8 wt% of a photoinitiator component, based on the total weight of the composition, said photoinitiator component including one or more free radical photoinitiators and one or more cationic photoinitiators.

2. The composition as claimed in claim 1, wherein the multifunctional epoxide component includes one or more difunctional cycloaliphatic epoxides and one or more difunctional aromatic epoxides.

3. The composition as claimed in claim 2, wherein an amount of the one or more difunctional aromatic epoxides is from 5 wt% to 60 wt% based on the total weight of the multifunctional epoxide component.

4. The composition as claimed in any one of claims 1 to 3, wherein the multifunctional epoxide component includes divinylbenzene dioxide in an amount from 5 wt% to 60 wt%, based on the total weight of the composition.

5. The composition as claimed in any one of claims 1 to 4, wherein the monomer component includes one of:
(a) from 90 wt% to 100 wt% of one or more diacrylate monomers, based on the total weight of the monomer component,
(b) from 90 wt% to 100 wt% of one or more divinyl ether monomers, based on the total weight of the monomer component, or
(c) from 90 wt% to 100 wt% of one or more diacrylate monomers and one or more divinyl ether monomers, based on the total weight of the monomer component.

6. The composition as claimed in any one of claims 1 to 5, wherein the urethane acrylate component is a pre-formed component that is formed prior to forming the composition with the multifunctional epoxide component, the monomer component, and photoinitiator component.

7. A printed three-dimensional flexible article including the composition as claimed in any one of claims 1 to 6, the composition being photocured.

8. A printed three-dimensional flexible article formed using the composition as claimed in any one of claims 1 to 6 and a three dimensional printing device, the device including a dispense mechanism for dispensing the composition and a photocuring mechanism for photocuring the composition.

9. A stereolithography based three-dimensional printing process, comprising the stage of dispensing the composition as claimed in any one of claims 1 to 6 to form a flexible article.

## Patentansprüche

1. Eine lichthärtbare Zusammensetzung für dreidimensionales Drucken für ein auf biegsamem Material basierendes Objekt, wobei die Zusammensetzung Folgendes beinhaltet:
zu 20 Gew.-% bis 70 Gew.-%, bezogen auf das Gesamtgewicht der Zusammensetzung, eine Urethanacrylatkomponente, wobei die Urethanacrylatkomponente das Cappingreaktionsprodukt eines Acrylats und eines isocyanatterminierten Präpolymers umfasst, wobei das isocyanatterminierte Präpolymer das Reaktionsprodukt eines Polyisocyanats und mindestens eines Polyols mit einem Molekulargewicht von mindestens 3000 g/mol ist;
zu 20 Gew.-% bis 60 Gew.-%, bezogen auf das Gesamtgewicht der Zusammensetzung, eine Komponente mehrfunktionellen Epoxids, die ein oder mehrere mehrfunktionelle Epoxide umfasst;
zu 1 Gew.-% bis 15.-Gew.-%, bezogen auf das Gesamtgewicht der Zusammensetzung, eine Monomerkomponente, die mindestens eines von einem mehrfunktionellen Acrylatmonomer und einem mehrfunktionellen Vinylethermonomer umfasst; und
zu 1 Gew.-% bis 8 Gew.-%, bezogen auf das Gesamtgewicht der Zusammensetzung, eine Photoinitiatorkomponente, wobei die Photoinitiatorkomponente einen oder
mehrere Radikalphotoinitiatoren und einen oder mehrere kationische Photoinitiatoren umfasst.

2. Zusammensetzung gemäß Anspruch 1, wobei die Komponente mehrfunktionellen Epoxids ein oder mehrere bifunktionelle cycloaliphatische Epoxide und ein oder mehrere bifunktionelle aromatische Epoxide umfasst.

3. Zusammensetzung gemäß Anspruch 2, wobei eine Menge des einen oder der mehreren bifunktionellen aromatischen Epoxide, bezogen auf das Gesamtgewicht der Komponente mehrfunktionellen Epoxids, 5 Gew.-% bis 60 Gew.-% beträgt.

4. Zusammensetzung gemäß einem der Ansprüche 1 bis 3, wobei die Komponente mehrfunktionellen Epoxids, bezogen auf das Gesamtgewicht der Zusammensetzung, Divinylbenzoldioxid in einer Menge von 5 Gew.-% bis 60 Gew.-% umfasst.

5. Zusammensetzung gemäß einem der Ansprüche 1 bis 4, wobei die Monomerkomponente eines von Folgendem umfasst:
(a) zu 90 Gew.-% bis 100 Gew.-%, bezogen auf das Gesamtgewicht der Monomerkomponente, ein oder mehrere Diacrylatmonomere,
(b) zu 90 Gew.-% bis 100 Gew.-%, bezogen auf das Gesamtgewicht der Monomerkomponente, ein oder mehrere Divinylethermonomere, oder
(c) zu 90 Gew.-% bis 100 Gew.-%, bezogen auf das Gesamtgewicht der Monomerkomponente, ein oder mehrere Diacrylatmonomere und ein oder mehrere Divinylethermonomere.

6. Zusammensetzung gemäß einem der Ansprüche 1 bis 5, wobei die Urethanacrylatkomponente eine vorgeformte Komponente ist, die vor dem Formen der Zusammensetzung mit der Komponente mehrfunktionellen Epoxids, der Monomerkomponente und der Photoinitiatorkomponente geformt wird.

7. Ein gedruckter dreidimensionaler biegsamer Artikel, der die Zusammensetzung gemäß einem der Ansprüche 1 bis 6 umfasst, wobei die Zusammensetzung lichtgehärtet ist.

8. Ein gedruckter dreidimensionaler biegsamer Artikel, der unter Verwendung der Zusammensetzung gemäß einem der Ansprüche 1 bis 6 und einer Vorrichtung für dreidimensionales Drucken geformt ist, wobei die Vorrichtung einen Ausgabemechanismus zum Ausgeben der Zusammensetzung und einen Lichthärtemechanismus zum Lichthärten der Zusammensetzung umfasst.

9. Ein auf Stereolithographie basierendes Verfahren für dreidimensionales Drucken, das die Stufe des Ausgebens der Zusammensetzung gemäß einem der Ansprüche 1 bis 6 zum Formen eines biegsamen Artikels beinhaltet.

## Revendications

1. Une composition photodurcissable d'impression tridimensionnelle pour un objet à base de matériau souple, la composition comprenant :
de 20 % en poids à 70 % en poids d'un constituant d'uréthane acrylate, rapporté au poids total de la composition, le constituant d'uréthane acrylate incluant le produit de la réaction de coiffage d'un acrylate et d'un prépolymère à terminaison isocyanate, le prépolymère à terminaison isocyanate étant le produit de la réaction d'un polyisocyanate et d'au moins un polyol ayant une masse moléculaire d'au moins 3 000 g/mol ;
de 20 % en poids à 60 % en poids d'un constituant époxyde multifonctionnel qui inclut un ou plusieurs époxydes multifonctionnels, rapporté au poids total de la composition ;
de 1 % en poids à 15 % en poids d'un constituant monomère qui inclut au moins un monomère parmi un monomère acrylate multifonctionnel et un monomère d'éther vinylique multifonctionnel, rapporté au poids total de la composition ; et
de 1 % en poids à 8 % en poids d'un constituant photo-initiateur, rapporté au poids total de la composition, ledit constituant photo-initiateur incluant un ou plusieurs photo-initiateurs à radical libre et un ou plusieurs photo-initiateurs cationiques.

2. La composition telle que revendiquée dans la revendication 1, dans laquelle le constituant époxyde multifonctionnel inclut un ou plusieurs époxydes cycloaliphatiques difonctionnels et un ou plusieurs époxydes aromatiques difonctionnels.

3. La composition telle que revendiquée dans la revendication 2, dans laquelle une quantité des un ou plusieurs époxydes aromatiques difonctionnels va de 5 % en poids à 60 % en poids rapporté au poids total du constituant époxyde multifonctionnel.

4. La composition telle que revendiquée dans l'une quelconque des revendications 1 à 3, dans laquelle le constituant époxyde multifonctionnel inclut du dioxyde de divinylbenzène dans une quantité allant de 5 % en poids à 60 % en poids, rapporté au poids total de la composition.

5. La composition telle que revendiquée dans l'une quelconque des revendications 1 à 4, dans laquelle le constituant monomère inclut un élément parmi :
(a) de 90 % en poids à 100 % en poids d'un ou de plusieurs monomères diacrylate, rapporté au poids total du constituant monomère,
(b) de 90 % en poids à 100 % en poids d'un ou de plusieurs monomères d'éther divinylique, rapporté au poids total du constituant monomère, ou
(c) de 90 % en poids à 100 % en poids d'un ou de plusieurs monomères diacrylate et d'un ou de plusieurs monomères d'éther divinylique, rapporté au poids total du constituant monomère.

6. La composition telle que revendiquée dans l'une quelconque des revendications 1 à 5, dans laquelle le constituant d'uréthane acrylate est un constituant préformé qui est formé préalablement à la formation de la composition avec le constituant époxyde multifonctionnel, le constituant monomère, et le constituant photo-initiateur.

7. Un article souple tridimensionnel imprimé incluant la composition telle que revendiquée dans l'une quelconque des revendications 1 à 6, la composition étant photodurcie.

8. Un article souple tridimensionnel imprimé formé à l'aide de la composition telle que revendiquée dans l'une quelconque des revendications 1 à 6 et d'un dispositif d'impression tridimensionnelle, le dispositif incluant un mécanisme de distribution pour distribuer la composition et un mécanisme de photodurcissement pour le photodurcissement de la composition.

9. Un procédé d'impression tridimensionnelle à base de stéréolithographie, comprenant l'étape de distribution de la composition telle que revendiquée dans l'une quelconque des revendications 1 à 6 afin de former un article souple.
